# EUROPEAN PATENT APPLICATION

(11) **EP 4 826 761 A1**
(43) Date of publication of application: **21.10.2026**
(21) Application number: 24903702.9
(22) Date of filing: 11.12.2024
(51) Int. Cl.: H01L 21/304, C09K 13/08, C11D 1/00, C23F 11/00, H01L 21/308

(54) **COMPOSITION FOR SEMICONDUCTOR SUBSTRATE CLEANING, METHOD FOR CLEANING SEMICONDUCTOR SUBSTRATE, AND METHOD FOR PRODUCING SEMICONDUCTOR SUBSTRATE**

(30) Priority: 13.12.2023 US 202363609376 P
(71) Applicant: MITSUBISHI GAS CHEMICAL COMPANY, INC., Chiyoda-ku Tokyo 100-8324 (JP)
(72) Inventor: IDO Yuto, Mesa, Arizona 852129716 (US); KAWAI Ryuichiro, Mesa, Arizona 852129716 (US)
(74) Representative: Müller-Boré & Partner Patentanwälte PartG mbB
(86) International application number: PCT/JP2024/043722
(87) International publication number: WO 2025/127048

(57) **Abstract**

The present invention is able to provide a composition for semiconductor substrate cleaning, the composition containing: a component (A) that is at least one substance which is selected from the group consisting of hydrofluoric acid, a salt of hydrofluoric acid, an acid that has an anion represented by general formula (a) as a conjugate base, and a salt of the acid that has an anion represented by general formula (a) as a conjugate base; a component (B) that is a compound represented by general formula (b); a component (C) that is an oxidant; a component (D) that is a tungsten corrosion inhibitor; a component (E) that is an organic solvent; and a component (F) that is water. The component (E) contains at least one substance that is selected from the group consisting of tetrahydrofuran, acetone, and acetonitrile, and α represented by formula (I) is 0.2 to 1.1 inclusive.

## Description

### TECHNICAL FIELD

The present invention relates to a composition for semiconductor substrate cleaning, a method for cleaning a semiconductor substrate, and a method for producing a semiconductor substrate.

### BACKGROUND ART

The production of a semiconductor substrate in which semiconductor elements are highly integrated generally has a series of processes as follows: usually, a conductive thin film such as a metal film serving as conductive wiring, a low-dielectric-constant interlayer insulating film for insulating between conductive thin films, a hard mask, etc. are formed on a substrate such as a silicon wafer; then a photoresist is uniformly applied to the surface thereof to provide a photosensitive layer; this is subjected to the selective exposure and development treatment to form a desired photoresist pattern; next, the substrate on which the low-dielectric-constant interlayer insulating film, the hard mask, etc. are laminated is subjected to a dry etching process using the photoresist pattern as a mask to form a desired pattern on the substrate; and then the photoresist pattern, residues generated by the dry etching process, and the hard mask are removed by ashing with oxygen plasma, a cleaning solution, or the like.

In recent years, titanium nitride has been widely used as a hard mask. Further, copper, cobalt, tungsten, etc. are used for metal wiring.

For semiconductor substrates in which titanium nitride is used as a hard mask and coexists with metal wiring and a low-dielectric-constant interlayer insulating film on the surface, there is a need to remove titanium nitride without corroding the metal wiring and low-dielectric-constant interlayer insulating film.

As a method for removing titanium nitride by wet etching without corroding metal wiring, a cleaning method using a corrosion inhibitor has been examined.

For example, Patent Document 1 discloses a liquid composition having a pH value of 0 to 4, which contains an oxidizing agent including potassium permanganate, a fluorine compound, and a tungsten corrosion inhibitor that consists of two types of compounds such as alkylamine, for the purpose of removing titanium nitride without corroding tungsten, etc.

Patent Document 2 discloses a composition containing an oxidizing agent, an etchant, and a solvent, and substantially free of hydrogen peroxide, for the purpose of selectively removing titanium nitride and a photoresist etch residue material.

Patent Document 3 discloses a composition containing an oxidizing agent, an etchant, a corrosion inhibitor, a source of silica, water, and an organic solvent, and substantially free of hydrogen peroxide, for the purpose of selectively removing titanium nitride and a photoresist etch residue material.

Patent Document 4 discloses a composition containing an oxidizing agent, an etchant, a metal corrosion inhibitor, a chelating agent, and a solvent, for the purpose of selectively removing titanium nitride and a photoresist etch residue material from the surface of a microelectronic device.

### PRIOR ART DOCUMENTS

### PATENT DOCUMENTS

Patent Document 1: International Publication WO2015/111684 pamphlet
Patent Document 2: Japanese National-phase PCT Laid-Open Patent Publication No. 2015-506583
Patent Document 3: Japanese National-phase PCT Laid-Open Patent Publication No. 2016-510175
Patent Document 4: Japanese National-phase PCT Laid-Open Patent Publication No. 2016-527707

### SUMMARY OF THE INVENTION

### PROBLEMS TO BE SOLVED BY THE INVENTION

With higher level of integration of semiconductor elements, there is a demand for miniaturization of metal wiring of semiconductor substrates. As the metal wiring becomes finer, there is concern about the diffusion of metal atoms forming the wiring into semiconductor elements. Under such circumstances, use of tungsten, which has low atomic diffusion, for the metal wiring has been examined. However, when the amount of a tungsten corrosion inhibitor added is increased in order to ensure sufficient tungsten corrosion resistance while maintaining the removability of titanium nitride, there is a problem that the tungsten corrosion inhibitor precipitates.

Meanwhile, when the amount of the oxidizing agent used in the liquid composition disclosed in Patent Document 1 is reduced, corrosion of tungsten is suppressed. However, the removal rate of titanium nitride decreases. When the amount of the fluorine compound is increased in order to compensate for this, corrosion of the low-dielectric-constant interlayer insulating film composed of silicon dioxide or the like is caused. Thus, in the production of semiconductor substrates using tungsten for the metal wiring and titanium nitride for the hard mask, it is very difficult to remove titanium nitride without corroding the metal wiring and the low-dielectric-constant interlayer insulating film. Therefore, in the production of semiconductor substrates using tungsten for the metal wiring and titanium nitride for the hard mask, it has been desired to develop a composition for semiconductor substrate cleaning that is capable of removing titanium nitride without corroding the metal wiring and the low-dielectric-constant interlayer insulating film.

The problem to be solved by the present invention is to provide a composition for semiconductor substrate cleaning that is capable of selectively removing titanium nitride from a semiconductor substrate having titanium nitride, tungsten and a low-dielectric-constant interlayer insulating film, a method for cleaning a semiconductor substrate using the composition for semiconductor substrate cleaning, and a method for producing a semiconductor substrate.

### MEANS FOR SOLVING THE PROBLEMS

The applicant of the present application diligently made researches in order to solve the above-described problems and found that by adding a specific organic solvent to a composition for semiconductor substrate cleaning, the amount of a tungsten corrosion inhibitor added can be increased without causing precipitation of the tungsten corrosion inhibitor, and sufficient tungsten corrosion resistance can be ensured while maintaining the removability of titanium nitride, and thus the present invention was achieved.

Specifically, the present invention provides a composition for semiconductor substrate cleaning, a method for cleaning a semiconductor substrate, and a method for producing a semiconductor substrate described below.
<1> A composition for semiconductor substrate cleaning, the composition comprising:
   a component (A) that is at least one substance which is selected from the group consisting of hydrofluoric acid, a salt of hydrofluoric acid, an acid that has an anion represented by general formula (a) as a conjugate base, and a salt of the acid that has an anion represented by general formula (a) as a conjugate base;

      [MFₙ]^{(n-k)-} (a)
   a component (B) that is a compound represented by general formula (b);

      [MOₘ(OR)ₖ₋₂ₘ]ₓ (b)

      wherein in general formulae (a) and (b), M is at least one element selected from the group consisting of boron, silicon, zirconium, antimony, niobium, aluminum, phosphorus and titanium, k is the oxidation number of M, m is an integer of 0 to k/2, x is a positive integer, R is one selected from the group consisting of a hydrogen atom, an alkali metal and an alkyl group, and n is the coordination number of fluoride ions with respect to M,
   a component (C) that is an oxidant;
   a component (D) that is a tungsten corrosion inhibitor;
   a component (E) that is an organic solvent; and
   a component (F) that is water, wherein
      the component (E) comprises at least one substance selected from the group consisting of tetrahydrofuran, acetone, and acetonitrile, and
      α represented by formula (I) is 0.2 to 1.1 inclusive: $α = \frac{\left[F\right]}{\sum \left(n\left(M\right)⋅\left[M\right]\right)}$ (I)
      wherein in formula (I), [F] is the molar concentration of the fluoride ions in the composition, [M] is the molar concentration of M in the composition, and n(M) is the coordination number of the fluoride ions with respect to M.
<2> The composition for semiconductor substrate cleaning according to item <1>, wherein the component (A) comprises at least one substance selected from the group consisting of hydrofluoric acid, hexafluorosilicic acid, tetrafluoroboric acid, a salt of hexafluorosilicic acid, and a salt of tetrafluoroboric acid.
<3> The composition for semiconductor substrate cleaning according to item <1> or <2>, wherein the component (B) comprises at least one substance selected from the group consisting of boric acid, a salt of boric acid, silicic acid, a salt of silicic acid, orthosilicic acid, and a salt of orthosilicic acid.
<4> The composition for semiconductor substrate cleaning according to any one of items <1> to <3>, wherein the component (C) comprises at least one substance selected from the group consisting of vanadium(V) oxide, vanadic acid (V), a salt of vanadic acid (V), iodic acid, a salt of iodic acid, orthoperiodic acid, and a salt of orthoperiodic acid.
<5> The composition for semiconductor substrate cleaning according to any one of items <1> to <4>, wherein the component (D) comprises at least one substance selected from the group consisting of benzethonium chloride, benzalkonium chloride, alkylpyridinium chloride, and quaternary ammonium salt.
<6> The composition for semiconductor substrate cleaning according to any one of items <1> to <5>, which is used for removing titanium nitride from a semiconductor substrate having titanium nitride, tungsten and a low-dielectric-constant interlayer insulating film.
<7> The composition for semiconductor substrate cleaning according to any one of items <1> to <6>, wherein the content of the component (A) is 0.1 to 10% by mass relative to the total amount of the composition for semiconductor substrate cleaning.
<8> The composition for semiconductor substrate cleaning according to any one of items <1> to <7>, wherein the content of the component (B) is 0.005 to 5% by mass relative to the total amount of the composition for semiconductor substrate cleaning.
<9> The composition for semiconductor substrate cleaning according to any one of items <1> to <8>, wherein the content of the component (C) is 0.0005 to 1% by mass relative to the total amount of the composition for semiconductor substrate cleaning.
<10> The composition for semiconductor substrate cleaning according to any one of items <1> to <9>, wherein the content of the component (D) is 0.0005 to 1% by mass relative to the total amount of the composition for semiconductor substrate cleaning.
<11> The composition for semiconductor substrate cleaning according to any one of items <1> to <10>, wherein the content of the component (E) is 0.1 to 50% by mass relative to the total amount of the composition for semiconductor substrate cleaning.
<12> The composition for semiconductor substrate cleaning according to any one of items <1> to <11>, wherein the component (A) is at least one substance selected from the group consisting of an acid that has an anion represented by general formula (a) as a conjugate base and a salt of the acid that has an anion represented by general formula (a) as a conjugate base, and wherein the ratio between the content (mol) of the component (A) and the content (mol) of the component (B) [(A)/(B)] is 1 to 100.
<13> The composition for semiconductor substrate cleaning according to any one of items <1> to <12>, wherein when a substrate having tungsten and titanium nitride is immersed in the composition for semiconductor substrate cleaning and kept at 60°C, titanium nitride is removed at a removal rate of 80 Å/min or more and tungsten is removed at a removal rate of 3 Å/min or less.
<14> The composition for semiconductor substrate cleaning according to any one of items <1> to <12>, wherein when a substrate having a low-dielectric-constant interlayer insulating film and titanium nitride is immersed in the composition for semiconductor substrate cleaning and kept at 60°C, titanium nitride is removed at a removal rate of 80 Å/min or more and the low-dielectric-constant interlayer insulating film is removed at a removal rate of 3 Å/min or less.
<15> A method for cleaning a semiconductor substrate, wherein a substrate having titanium nitride, tungsten and a low-dielectric-constant interlayer insulating film is brought into contact with the composition for semiconductor substrate cleaning according to any one of items <1> to <14>.
<16> A method for producing a semiconductor substrate, the method comprising a step of bringing a substrate having titanium nitride, tungsten and a low-dielectric-constant interlayer insulating film into contact with the composition for semiconductor substrate cleaning according to any one of items <1> to <14>.

### ADVANTAGEOUS EFFECT OF THE INVENTION

The composition for semiconductor substrate cleaning of the present invention can selectively remove titanium nitride from a semiconductor substrate having titanium nitride, tungsten and a low-dielectric-constant interlayer insulating film.

That is, by using the composition for semiconductor substrate cleaning of the present invention, titanium nitride can be removed particularly while suppressing corrosion of tungsten.

Therefore, it becomes possible to clean and produce semiconductor substrates having fine metal wiring, and higher level of integration of semiconductor devices can be realized.

### EMBODIMENTS FOR CARRYING OUT THE INVENTION

The present invention relates to a composition for semiconductor substrate cleaning, the composition containing:
a component (A) that is at least one substance which is selected from the group consisting of hydrofluoric acid, a salt of hydrofluoric acid, an acid that has an anion represented by general formula (a) as a conjugate base, and a salt of the acid that has an anion represented by general formula (a) as a conjugate base;

   [MFₙ]^{(n-k)-} (a)
a component (B) that is a compound represented by general formula (b);

   [MOₘ(OR)ₖ₋₂ₘ]ₓ (b)

   wherein in general formulae (a) and (b), M is at least one element selected from the group consisting of boron, silicon, zirconium, antimony, niobium, aluminum, phosphorus and titanium, k is the oxidation number of M, m is an integer of 0 to k/2, x is a positive integer, R is one selected from the group consisting of a hydrogen atom, an alkali metal and an alkyl group, and n is the coordination number of fluoride ions with respect to M,
a component (C) that is an oxidant; a component (D) that is a tungsten corrosion inhibitor; a component (E) that is an organic solvent; and a component (F) that is water, wherein the component (E) contains at least one substance selected from the group consisting of tetrahydrofuran, acetone, and acetonitrile, and α represented by formula (I) is 0.2 to 1.1 inclusive, and also relates to a cleaning method using the composition for semiconductor substrate cleaning and a method for producing a semiconductor substrate. $α = \frac{\left[F\right]}{\sum \left(n\left(M\right)⋅\left[M\right]\right)}$ (I)

In formula (I), [F] is the molar concentration of the fluoride ions in the composition, [M] is the molar concentration of M in the composition, and n(M) is the coordination number of the fluoride ions with respect to M.

### [Composition for Semiconductor Substrate Cleaning]

The composition for semiconductor substrate cleaning of the present invention contains:
a component (A) that is at least one substance which is selected from the group consisting of hydrofluoric acid, a salt of hydrofluoric acid, an acid that has an anion represented by general formula (a) as a conjugate base, and a salt of the acid that has an anion represented by general formula (a) as a conjugate base;

   [MFₙ]^{(n-k)-} (a)
a component (B) that is a compound represented by general formula (b);

   [MOₘ(OR)ₖ₋₂ₘ]ₓ (b)

   wherein in general formulae (a) and (b), M is at least one element selected from the group consisting of boron, silicon, zirconium, antimony, niobium, aluminum, phosphorus and titanium, k is the oxidation number of M, m is an integer of 0 to k/2, x is a positive integer, R is one selected from the group consisting of a hydrogen atom, an alkali metal and an alkyl group, and n is the coordination number of fluoride ions with respect to M,
a component (C) that is an oxidant; a component (D) that is a tungsten corrosion inhibitor; a component (E) that is an organic solvent; and a component (F) that is water, wherein the component (E) contains at least one substance selected from the group consisting of tetrahydrofuran, acetone, and acetonitrile, and α represented by formula (I) is 0.2 to 1.1 inclusive. $α = \frac{\left[F\right]}{\sum \left(n\left(M\right)⋅\left[M\right]\right)}$ (I)

In formula (I), [F] is the molar concentration of the fluoride ions in the composition, [M] is the molar concentration of M in the composition, and n(M) is the coordination number of the fluoride ions with respect to M.

The composition for semiconductor substrate cleaning of the present invention contains the aforementioned components and the aforementioned α is a specific value, and therefore the composition can selectively remove titanium nitride from a semiconductor substrate having titanium nitride, tungsten and a low-dielectric-constant interlayer insulating film. Though it is not known exactly why the composition has such excellent properties, a possible reason therefor is as follows.

Fluoride ions, which are ions constituting the component (A), are necessary to remove titanium nitride, but at the same time, the fluoride ions corrode tungsten and the low-dielectric-constant interlayer insulating film. It is believed that by including the component (B), which is a compound having a specific element as the central element, in the composition for semiconductor substrate cleaning of the present invention in a manner such that the above-described specific value of α is satisfied, the nucleophilicity of the fluorine compound is appropriately reduced, and corrosion of tungsten, etc. can be suppressed while removing titanium nitride.

Hereinafter, the composition for semiconductor substrate cleaning of the present invention will be described in detail.

### <Component (A)>

The composition for semiconductor substrate cleaning of the present invention contains a component (A) that is at least one substance selected from the group consisting of hydrofluoric acid, a salt of hydrofluoric acid, an acid that has an anion represented by general formula (a) as a conjugate base, and a salt of the acid that has an anion represented by general formula (a) as a conjugate base.

[MFₙ]^{(n-k)-} (a)

In formula (a), M is at least one element selected from the group consisting of boron, silicon, zirconium, antimony, niobium, aluminum, phosphorus and titanium, k is the oxidation number of M, and n is the coordination number of fluoride ions with respect to M.

That is, the component (A) is at least one substance selected from the group consisting of hydrofluoric acid, a salt of hydrofluoric acid, an acid that has an anion represented by general formula (a) as a conjugate base, and a salt of the acid that has an anion represented by general formula (a) as a conjugate base.

The component (A) plays a role to release fluoride ions during cleaning to assist in removing titanium nitride.

Among them, the component (A) is preferably at least one substance selected from the group consisting of hydrofluoric acid and an acid that has an anion represented by general formula (a) as a conjugate base, and more preferably an acid that has an anion represented by general formula (a) as a conjugate base.

Examples of the salt of hydrofluoric acid include sodium fluoride, potassium fluoride, ammonium fluoride, sodium hydrogen fluoride, potassium hydrogen fluoride, and ammonium hydrogen fluoride.

In formula (a) which represents an anion constituting the acid that has the anion represented by general formula (a) as a conjugate base or salt thereof, M is at least one element selected from the group consisting of boron, silicon, zirconium, antimony, niobium, aluminum, phosphorus and titanium, preferably at least one element selected from the group consisting of boron, silicon, zirconium, phosphorus and titanium, and more preferably at least one element selected from the group consisting of boron and silicon.

Further, k is the oxidation number of M and varies depending on M. In general, k is 3 in the case of boron, 4 in the case of silicon, 4 in the case of zirconium, 5 in the case of phosphorus, and 4 in the case of titanium.

n is the coordination number of fluoride ions with respect to M and varies depending on M. In general, n is 4 in the case of boron, 6 in the case of silicon, 6 in the case of zirconium, 6 in the case of phosphorus, and 6 in the case of titanium.

Examples of the acid that has an anion represented by general formula (a) as a conjugate base include hexafluorosilicic acid, tetrafluoroboric acid, hexafluorozirconic acid, hexafluoroantimonic acid, hexafluoroniobic acid, hexafluoroaluminic acid, hexafluorotitanic acid, and hexafluorophosphoric acid.

Examples of the salt of the acid that has an anion represented by general formula (a) as a conjugate base include a salt of hexafluorosilicic acid, a salt of tetrafluoroboric acid, a salt of hexafluorozirconic acid, a salt of hexafluoroantimonic acid, a salt of hexafluoroniobic acid, a salt of hexafluoroaluminic acid, a salt of hexafluorotitanic acid, and a salt of hexafluorophosphoric acid.

Examples of a cation constituting the aforementioned salt include a sodium ion, a potassium ion, and an ammonium ion. That is, examples of the salt of the acid that has an anion represented by general formula (a) as a conjugate base include salts in which the hydrogen ion of each acid is substituted with the aforementioned cation. Specific examples of the salt include ammonium hexafluorophosphate.

From the viewpoint of achieving a balance between removal of titanium nitride and suppression of corrosion of tungsten and the low-dielectric-constant interlayer insulating film, the component (A) preferably contains at least one substance selected from the group consisting of hydrofluoric acid, hexafluorosilicic acid, tetrafluoroboric acid, hexafluorozirconic acid, hexafluorotitanic acid, hexafluorophosphoric acid, a salt of hexafluorosilicic acid, a salt of tetrafluoroboric acid, a salt of hexafluorozirconic acid, a salt of hexafluorotitanic acid, and a salt of hexafluorophosphoric acid, more preferably contains at least one substance selected from the group consisting of hydrofluoric acid, hexafluorosilicic acid, tetrafluoroboric acid, hexafluorozirconic acid, hexafluorotitanic acid, and hexafluorophosphoric acid, even more preferably contains at least one substance selected from the group consisting of hydrofluoric acid, hexafluorosilicic acid, and tetrafluoroboric acid, and still more preferably contains at least one substance selected from the group consisting of hexafluorosilicic acid and tetrafluoroboric acid.

Furthermore, in a preferred embodiment, the component (A) is preferably at least one substance selected from the group consisting of hydrofluoric acid, hexafluorosilicic acid, tetrafluoroboric acid, hexafluorozirconic acid, hexafluorotitanic acid, hexafluorophosphoric acid, a salt of hexafluorosilicic acid, a salt of tetrafluoroboric acid, a salt of hexafluorozirconic acid, a salt of hexafluorotitanic acid, and a salt of hexafluorophosphoric acid, more preferably at least one substance selected from the group consisting of hydrofluoric acid, hexafluorosilicic acid, tetrafluoroboric acid, hexafluorozirconic acid, hexafluorotitanic acid, and hexafluorophosphoric acid, even more preferably at least one substance selected from the group consisting of hydrofluoric acid, hexafluorosilicic acid, and tetrafluoroboric acid, and still more preferably at least one substance selected from the group consisting of hexafluorosilicic acid and tetrafluoroboric acid.

As the component (A), only one type may be contained in the composition for semiconductor substrate cleaning of the present invention, and two or more types may be contained therein. For example, both hydrofluoric acid and the acid that has an anion represented by general formula (a) as a conjugate base may be contained, or as the acid that has an anion represented by general formula (a) as a conjugate base, two or more types may be contained.

The content of the component (A) in the composition for semiconductor substrate cleaning of the present invention is preferably 0.1 to 10% by mass, more preferably 0.3 to 8.0% by mass, even more preferably 0.5 to 6.0% by mass, and still more preferably 1.0 to 5.0% by mass relative to the total amount of the composition for semiconductor substrate cleaning. By adjusting the content of the component (A) within the above-described range, titanium nitride can be removed while suppressing corrosion of tungsten and the low-dielectric-constant interlayer insulating film.

### <Component (B)>

The composition for semiconductor substrate cleaning of the present invention contains a component (B) that is a compound represented by general formula (b).

[MOₘ(OR)ₖ₋₂ₘ]ₓ (b)

In formula (b), M is at least one element selected from the group consisting of boron, silicon, zirconium, antimony, niobium, aluminum, phosphorus and titanium, k is the oxidation number of M, m is an integer of 0 to k/2, x is a positive integer, and R is one selected from the group consisting of a hydrogen atom, an alkali metal and an alkyl group.

It is believed that the nucleophilicity of the component (A) is suitably reduced by the component (B), thereby achieving a balance between removal of titanium nitride and suppression of corrosion of tungsten and the low-dielectric-constant interlayer insulating film.

In formula (b) representing the compound of the component (B), M is at least one element selected from the group consisting of boron, silicon, zirconium, antimony, niobium, aluminum, phosphorus and titanium, preferably at least one element selected from the group consisting of boron, silicon, zirconium, phosphorus and titanium, and more preferably at least one element selected from the group consisting of boron and silicon.

Further, k is the oxidation number of M and varies depending on M. In general, k is 3 in the case of boron, 4 in the case of silicon, 4 in the case of zirconium, 5 in the case of phosphorus, and 4 in the case of titanium.

R is one selected from the group consisting of a hydrogen atom, an alkali metal and an alkyl group. Specifically, when R is a hydrogen atom, the component (B) is a compound having a hydroxyl group, and when R is an alkali metal, the component (B) is a salt of an acid having M as the central metal, and when R is an alkyl group, the component (B) is an alkoxide.

m is an integer of 0 to k/2. When m is k/2, the component (B) is an oxide of M.

x is a positive integer. When x is 1, the component (B) is a compound having one M in the molecule, and when x is 2 or more, the component (B) is a polymer in which a plurality of compounds each having one M in the molecule are bonded. When x is 2 or more, the component (B) preferably has a cyclic structure.

From the viewpoint of achieving a balance between removal of titanium nitride and suppression of corrosion of tungsten and the low-dielectric-constant interlayer insulating film, the component (B) preferably contains at least one substance selected from the group consisting of boric acid, a salt of boric acid, silicon dioxide, silicic acid, a salt of silicic acid, orthosilicic acid, a salt of orthosilicic acid, alkoxysilane, zirconium oxide, zirconic acid, and a salt of zirconic acid, more preferably contains at least one substance selected from the group consisting of boric acid, silicon dioxide, silicic acid, and a salt of silicic acid, even more preferably contains at least one substance selected from the group consisting of boric acid, silicon dioxide, and a salt of silicic acid, and still more preferably contains at least one substance selected from the group consisting of boric acid and a salt of silicic acid.

Furthermore, in a preferred embodiment, the component (B) is preferably at least one substance selected from the group consisting of boric acid, a salt of boric acid, silicon dioxide, silicic acid, a salt of silicic acid, orthosilicic acid, a salt of orthosilicic acid, alkoxysilane, zirconium oxide, zirconic acid, and a salt of zirconic acid, more preferably at least one substance selected from the group consisting of boric acid, silicon dioxide, silicic acid, and a salt of silicic acid, even more preferably at least one substance selected from the group consisting of boric acid, silicon dioxide, and a salt of silicic acid, and still more preferably at least one substance selected from the group consisting of boric acid and a salt of silicic acid.

Examples of a cation constituting the aforementioned salts include a sodium ion, a potassium ion, and an ammonium ion. That is, examples of the salt of boric acid, the salt of silicic acid, the salt of orthosilicic acid, and the salt of zirconic acid include salts in which the hydrogen ion of each acid is substituted with the aforementioned cation. Specific examples of the salts include sodium metasilicate and potassium silicate.

As the component (B), only one type may be contained in the composition for semiconductor substrate cleaning of the present invention, and two or more types may be contained therein.

The content of the component (B) in the composition for semiconductor substrate cleaning of the present invention is preferably 0.005 to 5% by mass, more preferably 0.01 to 3.0% by mass, even more preferably 0.02 to 2.0% by mass, and still more preferably 0.03 to 1.0% by mass relative to the total amount of the composition for semiconductor substrate cleaning. By adjusting the content of the component (B) within the above-described range, titanium nitride can be removed while suppressing corrosion of tungsten and the low-dielectric-constant interlayer insulating film.

### <Component (C): Oxidant>

The composition for semiconductor substrate cleaning of the present invention contains a component (C) that is an oxidant.

The component (C) is contained in the composition in order to efficiently remove titanium nitride.

As the component (C), generally known oxidants can be used.

Among them, from the viewpoint of achieving a balance between removal of titanium nitride and suppression of corrosion of tungsten and the low-dielectric-constant interlayer insulating film, the component (C) is preferably at least one substance selected from the group consisting of vanadium(V) oxide, vanadic acid (V), a salt of vanadic acid (V), permanganic acid, a salt of permanganic acid, iodic acid, a salt of iodic acid, orthoperiodic acid, a salt of orthoperiodic acid, perchloric acid, a salt of perchloric acid, diammonium cerium(IV) nitrate, ammonium iron(III) sulfate, ammonium peroxodisulfate, iron(III) chloride, ammonium nitrate, t-butyl hydroperoxide, N-methylmorpholine N-oxide, and trimethylamine N-oxide, more preferably at least one substance selected from the group consisting of vanadium(V) oxide, a salt of permanganic acid, iodic acid, a salt of iodic acid, periodic acid, perchloric acid, a salt of perchloric acid, diammonium cerium(IV) nitrate, ammonium iron(III) sulfate, ammonium peroxodisulfate, ammonium nitrate, and N-methylmorpholine N-oxide, and even more preferably at least one substance selected from the group consisting of vanadium(V) oxide, iodic acid, and periodic acid.

Examples of a cation constituting the aforementioned salts include a sodium ion, a potassium ion, and an ammonium ion. That is, examples of the salt of vanadic acid (V), the salt of permanganic acid, the salt of iodic acid, the salt of orthoperiodic acid, and the salt of perchloric acid include salts in which the hydrogen ion of each acid is substituted with the aforementioned cation. Specific examples of the salts include potassium permanganate.

As the component (C), only one type may be contained in the composition for semiconductor substrate cleaning of the present invention, and two or more types may be contained therein.

The content of the component (C) in the composition for semiconductor substrate cleaning of the present invention is preferably 0.0005 to 1% by mass, more preferably 0.0008 to 0.2% by mass, even more preferably 0.0010 to 0.1% by mass, still more preferably 0.0010 to 0.05% by mass, and particularly preferably 0.0015 to 0.03% by mass relative to the total amount of the composition for semiconductor substrate cleaning. By adjusting the content of the component (C) within the above-described range, titanium nitride can be removed while suppressing corrosion of tungsten and the low-dielectric-constant interlayer insulating film.

Since the objective of the composition for semiconductor substrate cleaning of the present invention is to suppress corrosion of tungsten and the low-dielectric-constant interlayer insulating film during cleaning, it is preferred to avoid using an oxidant having strong oxidation power as much as possible, and even if it is used, the amount thereof is preferably very small.

Preferably, the composition for semiconductor substrate cleaning of the present invention substantially does not contain hydrogen peroxide, p-benzoquinone, copper(II) nitrate, sodium peroxoborate, bromic acid or a salt of bromic acid. The wording "substantially does not contain" means that the content is equal to or less than an amount that does not impair the effects of the composition for semiconductor substrate cleaning of the present invention.

When hydrogen peroxide, p-benzoquinone, copper(II) nitrate, sodium peroxoborate, bromic acid or a salt of bromic acid is contained, the total content thereof is preferably less than 0.0015% by mass, more preferably less than 0.0010% by mass, even more preferably less than 0.0008% by mass, and still more preferably less than 0.0005% by mass relative to the total amount of the composition for semiconductor substrate cleaning, and yet more preferably, the composition does not contain hydrogen peroxide, p-benzoquinone, copper(II) nitrate, sodium peroxoborate, bromic acid or a salt of bromic acid.

### <Component (D): Tungsten Corrosion Inhibitor>

The composition for semiconductor substrate cleaning of the present invention contains a component (D) that is a tungsten corrosion inhibitor.

The tungsten corrosion inhibitor to be used in the present invention is not particularly limited and publicly-known tungsten corrosion inhibitors can be used.

Examples thereof include alkylamines and salts thereof, fluoroalkylamines and salts thereof, alkylamine oxides, fluoroalkylamine oxides, alkyl betaines, fluoroalkyl betaines, alkyl quaternary ammoniums and salts thereof, fluoroalkyl quaternary ammoniums and salts thereof, alkyl pyridinium chlorides, fluoroalkyl quaternary pyridinium salts, alkyl quaternary bipyridinium salts, fluoroalkyl quaternary bipyridinium salts, alkyl quaternary imidazolium salts, and fluoroalkyl quaternary imidazolium salts.

Specific examples of alkylamines and salts thereof or fluoroalkylamines and salts thereof include octylamine, decylamine, dodecylamine, tetradecylamine, hexadecylamine, octadecylamine, dodecylamine hydrochloride, perfluorododecylamine, dioctylamine, didecylamine, didodecylamine, trioctylamine, tridecylamine, tridodecylamine, octyldimethylamine, decyldimethylamine, and dodecyldimethylamine. Among them, dodecylamine, tetradecylamine, and hexadecylamine are preferred.

Specific examples of alkylamine oxides or fluoroalkylamine oxides include N-decyl-N,N-dimethylamine oxide, N-dodecyl-N,N-dimethylamine oxide, N-tetradecyl-N,N-dimethylamine oxide, N-hexadecyl-N,N-dimethylamine oxide, SURFLON S-241 (trade name, perfluoroalkylamine oxide manufactured by AGC Seimi Chemical Co., Ltd.), and AMOGEN (trade name, alkylamine oxide manufactured by DKS Co. Ltd.). Among them, SURFLON S-241 is preferred.

Specific examples of alkyl betaines or fluoroalkyl betaines include dodecyl dimethyl amino acetic acid betaine, perfluoro dodecyl dimethyl amino acetic acid betaine, dodecyl dimethyl amino sulfobetaine, perfluoro dodecyl dimethyl amino sulfobetaine, and AMPHITOL (trade name, alkyl betaine manufactured by DKS Co. Ltd.). Among them, AMPHITOL 20YB and AMPHITOL 24B are preferred.

Specific examples of alkyl quaternary ammoniums and salts thereof or fluoroalkyl quaternary ammoniums and salts thereof include dodecyl trimethyl ammonium hydroxide, tetradecyl trimethyl ammonium hydroxide, hexadecyl trimethyl ammonium hydroxide, benzyl dimethyl decyl ammonium hydroxide, benzyl dimethyl dodecyl ammonium hydroxide, benzyl dimethyl tetradecyl ammonium hydroxide, benzyl dimethyl hexadecyl ammonium hydroxide, dodecyl trimethyl ammonium hydroxide, tetradecyl trimethyl ammonium hydroxide, hexadecyl trimethyl ammonium hydroxide, dodecyl trimethyl ammonium chloride, tetradecyl trimethyl ammonium chloride, hexadecyl trimethyl ammonium chloride, benzyl dimethyl decyl ammonium chloride, benzyl dimethyl dodecyl ammonium chloride, benzyl dimethyl tetradecyl ammonium chloride, benzyl dimethyl hexadecyl ammonium chloride, benzalkonium chloride, benzethonium chloride, Ethoquad (trade name, polyoxyethylene-added-type quaternary ammonium chloride manufactured by Lion Corporation), Fluorad FC-135 (trade name, perfluoroalkyl quaternary ammonium iodide manufactured by Sumitomo 3M Ltd.), QUARTAMIN (trade name, alkyl quaternary ammonium chloride manufactured by Kao Corporation), and CATIOGEN (trade name, alkyl quaternary ammonium ethyl sulfate manufactured by DKS Co. Ltd.). Among them, benzalkonium chloride, benzethonium chloride, dodecyl trimethyl ammonium chloride, hexadecyl trimethyl ammonium chloride, and Fluorad FC-135 are preferred.

Specific examples of alkyl pyridinium chlorides or fluoroalkyl quaternary pyridinium salts include 1-decylpyridinium chloride, 1-dodecylpyridinium chloride, 1-tetradecylpyridinium chloride, 1-hexadecylpyridinium chloride, and 1-hexadecyl-4-methylpyridinium chloride. Among them, 1-dodecylpyridinium chloride and 1-hexadecyl-4-methylpyridinium chloride are preferred.

Specific examples of alkyl quaternary bipyridinium salts or fluoroalkyl quaternary bipyridinium salts include 1,1'-di-n-octyl-4,4'-bipyridinium dibromide, 1-methyl-1'-tetradecyl-4,4'-bipyridinium dibromide, and 1,1'-di-n-perfluorooctyl-4,4'-bipyridinium dibromide. Among them, 1,1'-di-n-octyl-4,4'-bipyridinium dibromide is preferred.

Specific examples of alkyl quaternary imidazolium salts or fluoroalkyl quaternary imidazolium salts include 1-octyl-3-methylimidazolium chloride, 1-decyl-3-methylimidazolium chloride, 1-dodecyl-3-methylimidazolium chloride, 1-tetradecyl-3-methylimidazolium chloride, 1-hexadecyl-3-methylimidazolium chloride, 1-octadecyl-3-methylimidazolium chloride, 1,3-didecyl-2-methylimidazolium chloride, and 1-perfluorooctyl imidazolium chloride. Among them, 1-dodecyl-3-methylimidazolium chloride, 1-tetradecyl-3-methylimidazolium chloride, 1-hexadecyl-3-methylimidazolium chloride, 1-octadecyl-3-methylimidazolium chloride, and 1,3-didecyl-2-methylimidazolium chloride are preferred.

Examples of other tungsten corrosion inhibitors include polyoxyalkylene alkylamines, polyoxyalkylene fluoroalkylamines, polyoxyalkylene alkyl ethers, polyoxyalkylene fluoroalkyl ethers, polyoxyalkylene alkyl phosphates, polyoxyalkylene fluoroalkyl phosphates, polyoxyalkylene alkyl ether sulfates, polyoxyalkylene fluoroalkyl ether sulfates, alkyl diphenyl ether sulfonates, and fluoroalkyl diphenyl ether sulfonates.

Specific examples of polyoxyalkylene alkylamines or polyoxyalkylene fluoroalkylamines include NYMEEN (trade name, polyoxyethylene alkylamine manufactured by Nippon Oil & Fats Co., Ltd.) and NOIGEN (trade name, polyoxyethylene alkylamine manufactured by DKS Co. Ltd.). Among them, NYMEEN F-215, NOIGEN ET-189, and NOIGEN XL-140 are preferred.

Specific examples of polyoxyalkylene alkyl ethers or polyoxyalkylene fluoroalkyl ethers include Newcol (trade name, alkyl ether-type nonionic surfactant manufactured by Nippon Nyukazai Co., Ltd.), Ftergent (trade name, polyoxyethylene perfluoroalkyl ether manufactured by Neos Company Limited), and ANTI-FROTH (trade name, special nonionic surfactant manufactured by DKS Co. Ltd.). Among them, Newcol 2308-LY, ANTI-FROTH M-9, Ftergent 222F, Ftergent 250, and Ftergent 251 are preferred.

Specific examples of polyoxyalkylene alkyl phosphates or polyoxyalkylene fluoroalkyl phosphates include Phosphanol (trade name, polyoxyethylene phosphate manufactured by TOHO Chemical Industry Co., Ltd.). Among them, Phosphanol RA-600, Phosphanol RS-710, Phosphanol RL-310, Phosphanol ED-230, Phosphanol iD10-P, Phosphanol ML-240, and Phosphanol OF-100 are preferred.

Specific examples of polyoxyalkylene alkyl ether sulfates or polyoxyalkylene fluoroalkyl ether sulfates include HITENOL (trade name, polyoxyethylene alkyl ether sulfonic acid manufactured by DKS Co. Ltd.). Among them, HITENOL NF-08, HITENOL NF-13, and HITENOL NF-17 are preferred.

Specific examples of alkyl diphenyl ether sulfonates or fluoroalkyl diphenyl ether sulfonates include PELEX (trade name, alkyl diphenyl ether disulfonate manufactured by Kao Corporation). Among them, PELEX SS-H and PELEX SS-L are preferred.

In the present invention, the component (D) preferably contains at least one substance selected from the group consisting of benzethonium chloride, benzalkonium chloride, alkylpyridinium chloride, and quaternary ammonium salt.

The content of the component (D) in the composition for semiconductor substrate cleaning of the present invention is preferably 0.0005 to 1% by mass, more preferably 0.0008 to 0.8% by mass, even more preferably 0.0010 to 0.6% by mass, still more preferably 0.0012 to 0.5% by mass, and particularly preferably 0.0015 to 0.3% by mass relative to the total amount of the composition for semiconductor substrate cleaning. By adjusting the content of the component (D) within the above-described range, sufficient tungsten corrosion protection performance can be obtained. When the content of the tungsten corrosion inhibitor is less than 0.0005% by mass, sufficient corrosion protection performance may not be obtained, and when the content exceeds 1% by mass, it is not economical, is not suitable for practical use, and precipitation may occur.

### <Component (E): Organic Solvent>

The composition for semiconductor substrate cleaning of the present invention contains a component (E) that is an organic solvent.

In the present invention, the component (E) contains at least one substance selected from the group consisting of tetrahydrofuran, acetone, and acetonitrile.

By adding such a specific organic solvent, the addition amount of the tungsten corrosion inhibitor can be increased without causing precipitation of the tungsten corrosion inhibitor, and sufficient tungsten corrosion protection performance can be ensured while maintaining the titanium nitride removability.

The content of the component (E) in the composition for semiconductor substrate cleaning of the present invention is preferably 0.1 to 50% by mass, more preferably 0.5 to 20% by mass, even more preferably 1.0 to 15% by mass, and still more preferably 2.0 to 10% by mass relative to the total amount of the composition for semiconductor substrate cleaning.

### <Component (F): Water>

The composition for semiconductor substrate cleaning of the present invention contains a component (F) that is water.

The water is not particularly limited, but it is preferably water from which impurities such as metal ions, organic matter, and particles have been removed by distillation, ion exchange treatment, filtering treatment, adsorption treatment or the like. Pure water is more preferred, and ultrapure water is particularly preferred.

The content of the water is the remainder after removing the components (A) to (E) and other additives from the composition for semiconductor substrate cleaning of the present invention, and it is preferably 70% by mass or more, and more preferably 80 to 95% by mass relative to the total amount of the composition for semiconductor substrate cleaning. When the content of the water is within the above-described range, the effects of the present invention can be exhibited, and in addition, it is economical.

### <Characteristics, etc. of Composition for Semiconductor Substrate Cleaning>

The composition for semiconductor substrate cleaning of the present invention contains the aforementioned components (A) to (F), wherein α represented by formula (I) is 0.2 to 1.1 inclusive. $α = \frac{\left[F\right]}{\sum \left(n\left(M\right)⋅\left[M\right]\right)}$ çIà

In formula (I), [F] is the molar concentration of the fluoride ions in the composition, [M] is the molar concentration of M in the composition, and n(M) is the coordination number of the fluoride ions with respect to M.

In this regard, α is a value represented by formula (I) above, and is a value indicating the ratio between the fluoride ions contained in the component (A) and the element represented by M contained in the components (A) and (B).

When α is within the range of 0.2 to 1.1, a fluoro complex (fluorine-coordinated ate complex) is formed by the element contained in the component (B) together with the fluoride ions contained in the component (A), and it is considered that the nucleophilicity of the fluorine compound is appropriately reduced by gradually supplying the fluoride ions through an equilibrium reaction, which makes it possible to suppress corrosion of tungsten, etc. while removing titanium nitride.

α is 0.2 or more, preferably 0.4 or more, and more preferably 0.7 or more, and it is 1.1 or less, preferably 1.05 or less, and more preferably 1.0 or less. By adjusting the value of α within the above-described range, titanium nitride can be removed while suppressing corrosion of tungsten and the low-dielectric-constant interlayer insulating film.

In formula (I), α is calculated by dividing the molar concentration of the fluoride ions in the composition ([F]) by the product of the coordination number of the fluoride ions with respect to M (n(M)) and the molar concentration of M in the composition ([M]).

In this regard, M is an element used in the components (A) and (B), and specifically, it is at least one element selected from the group consisting of boron, silicon, zirconium, antimony, niobium, aluminum, phosphorus and titanium.

When a plurality of elements are used as M in the components (A) and (B), α is calculated by dividing the molar concentration of the fluoride ions in the composition ([F]) by the sum of each product of the coordination number of the fluoride ions with respect to each M (n(M)) and the molar concentration of each M in the composition.

For example, when M consists of two types that are M1 and M2, the denominator of the right hand side in formula (I) above is (n1(M1)·[M1] + n2(M2)·[M2]). In this regard, [M1] is the molar concentration of M1 in the composition, n1(M1) is the coordination number of the fluoride ions with respect to M1, [M2] is the molar concentration of M2 in the composition, and n2(M2) is the coordination number of the fluoride ions with respect to M2.

When the component (A) is at least one substance selected from the group consisting of the acid that has an anion represented by general formula (a) as a conjugate base and the salt of the acid that has an anion represented by general formula (a) as a conjugate base, the ratio between the content (mol) of the component (A) and the content (mol) of the component (B) [(A)/(B)] is preferably 1 to 100, more preferably 2 to 50, even more preferably 4 to 40, still more preferably 4 to 20, and particularly preferably 8 to 20. By adjusting the ratio between the molar content of the component (A) and the molar content of the component (B) within the above-described range, titanium nitride can be removed while suppressing corrosion of tungsten and the low-dielectric-constant interlayer insulating film.

Note that when x in formula (b) representing the compound of the component (B) exceeds 1, the "content (mol) of the component (B)" in the calculation of the aforementioned ratio is the amount obtained by multiplying the actual content of the component (B) contained in the composition for semiconductor substrate cleaning by x.

The pH of the composition for semiconductor substrate cleaning of the present invention is preferably 2 or lower, more preferably 1.5 or lower, even more preferably 1.0 or lower, and still more preferably 0.5 or lower. By adjusting the pH within the above-described range, in particular, corrosion of tungsten can be suppressed.

As described above, the composition for semiconductor substrate cleaning of the present invention is used for removing titanium nitride from a semiconductor substrate having titanium nitride, tungsten and a low-dielectric-constant interlayer insulating film. That is, the composition for semiconductor substrate cleaning of the present invention is a composition for semiconductor substrate cleaning which is used for removing titanium nitride from a semiconductor substrate having titanium nitride, tungsten and a low-dielectric-constant interlayer insulating film.

More specifically, the composition for semiconductor substrate cleaning of the present invention is a composition for semiconductor substrate cleaning which is used for removing titanium nitride from a semiconductor substrate having titanium nitride, tungsten and a low-dielectric-constant interlayer insulating film, the composition containing:
a component (A) that is at least one substance which is selected from the group consisting of hydrofluoric acid, a salt of hydrofluoric acid, an acid that has an anion represented by general formula (a) as a conjugate base, and a salt of the acid that has an anion represented by general formula (a) as a conjugate base;

   [MFₙ]^{(n-k)-} (a)
a component (B) that is a compound represented by general formula (b);

   [MOₘ(OR)ₖ₋₂ₘ]ₓ (b)

   wherein in formulae (a) and (b), M is at least one element selected from the group consisting of boron, silicon, zirconium, antimony, niobium, aluminum, phosphorus and titanium, k is the oxidation number of M, m is an integer of 0 to k/2, x is a positive integer, R is one selected from the group consisting of a hydrogen atom, an alkali metal and an alkyl group, and n is the coordination number of fluoride ions with respect to M,
a component (C) that is an oxidant; a component (D) that is a tungsten corrosion inhibitor; a component (E) that is an organic solvent; and a component (F) that is water, wherein the component (E) contains at least one substance selected from the group consisting of tetrahydrofuran, acetone, and acetonitrile, and α represented by formula (I) is 0.2 to 1.1 inclusive. $α = \frac{\left[F\right]}{\sum \left(n\left(M\right)⋅\left[M\right]\right)}$ (I)

In formula (I), [F] is the molar concentration of the fluoride ions in the composition, [M] is the molar concentration of M in the composition, and n(M) is the coordination number of the fluoride ions with respect to M.

When a substrate having tungsten and titanium nitride is immersed in the composition for semiconductor substrate cleaning of the present invention and kept at 60°C, preferably, titanium nitride can be removed by the composition at a removal rate of 80 Å/min or more, and tungsten is removed at a removal rate of 3 Å/min or less.

Since the composition for semiconductor substrate cleaning of the present invention has the above-described characteristics, it can selectively remove titanium nitride from a semiconductor substrate having tungsten. That is, by using the composition for semiconductor substrate cleaning of the present invention, titanium nitride can be removed particularly while suppressing corrosion of tungsten. Therefore, it becomes possible to clean and produce semiconductor substrates having fine metal wiring, and higher level of integration of semiconductor devices can be realized.

The removal rate for titanium nitride under the above-described conditions is preferably 80 Å/min or more, more preferably 120 Å/min or more, and even more preferably 160 Å/min or more. The higher the removal rate for titanium nitride under the above-described conditions is, the more efficiently titanium nitride can be removed, which is preferred, but the rate is usually 500 Å/min or less.

The removal rate for tungsten under the above-described conditions is preferably 3 Å/min or less, more preferably 2 Å/min or less, and even more preferably 1 Å/min or less. The lower the removal rate for tungsten under the above-described conditions is, the more corrosion of tungsten can be suppressed, which is preferred, but the rate is usually 0.1 Å/min or more.

The ratio between the removal rate for titanium nitride and the removal rate for tungsten under the above-described conditions is preferably 25 or more, more preferably 50 or more, and even more preferably 100 or more. The higher the ratio between the removal rate for titanium nitride and the removal rate for tungsten under the above-described conditions is, the more effectively titanium nitride can be selectively removed from a semiconductor substrate having tungsten, which is preferred, but the ratio is usually 5000 or less.

The specific measurement methods and conditions are as described in "(1) Etching Rate (ER)" in the Examples.

When a substrate having a low-dielectric-constant interlayer insulating film and titanium nitride is immersed in the composition for semiconductor substrate cleaning of the present invention and kept at 60°C, preferably, titanium nitride can be removed by the composition at a removal rate of 80 Å/min or more, and the low-dielectric-constant interlayer insulating film is removed at a removal rate of 3 Å/min or less.

Since the composition for semiconductor substrate cleaning of the present invention has the above-described characteristics, it can selectively remove titanium nitride from a semiconductor substrate having a low-dielectric-constant interlayer insulating film. Therefore, it becomes possible to clean and produce semiconductor substrates having fine metal wiring, and higher level of integration of semiconductor devices can be realized.

The removal rate for titanium nitride under the above-described conditions is preferably 80 Å/min or more, more preferably 120 Å/min or more, and even more preferably 160 Å/min or more. The higher the removal rate for titanium nitride under the above-described conditions is, the more efficiently titanium nitride can be removed, which is preferred, but the rate is usually 500 Å/min or less.

The removal rate for the low-dielectric-constant interlayer insulating film under the above-described conditions is preferably 3 Å/min or less, more preferably 2 Å/min or less, and even more preferably 1 Å/min or less. The lower the removal rate for the low-dielectric-constant interlayer insulating film under the above-described conditions is, the more effectively titanium nitride can be selectively removed from a semiconductor substrate having the low-dielectric-constant interlayer insulating film, which is preferred, but the rate is usually 0.1 Å/min or more.

The ratio between the removal rate for titanium nitride and the removal rate for the low-dielectric-constant interlayer insulating film under the above-described conditions is preferably 25 or more, more preferably 50 or more, and even more preferably 100 or more. The higher the ratio between the removal rate for titanium nitride and the removal rate for the low-dielectric-constant interlayer insulating film under the above-described conditions is, the more effectively titanium nitride can be selectively removed from a semiconductor substrate having the low-dielectric-constant interlayer insulating film, which is preferred, but the ratio is usually 5000 or less.

The specific measurement methods and conditions are as described in "(1) Etching Rate (ER)" in the Examples.

The aforementioned low-dielectric-constant interlayer insulating film is preferably a film made of a silicon compound, more preferably a TEOS film, a silicon dioxide film, or a silicon-containing organic polymer film, even more preferably a TEOS film or a silicon dioxide film, and still more preferably a TEOS film.

The silicon dioxide film is preferably a carbon-doped silicon dioxide film.

Among TEOS films, a PE-TEOS film (plasma TEOS film) is preferred.

### [Method for Cleaning Semiconductor Substrate]

The method for cleaning a semiconductor substrate of the present invention is a method for cleaning a semiconductor substrate, wherein a substrate having titanium nitride, tungsten and a low-dielectric-constant interlayer insulating film is brought into contact with the aforementioned composition for semiconductor substrate cleaning.

That is, the method for cleaning a semiconductor substrate of the present invention is a method for cleaning a semiconductor substrate, wherein a substrate having titanium nitride, tungsten and a low-dielectric-constant interlayer insulating film is brought into contact with a composition for semiconductor substrate cleaning, the composition containing:
a component (A) that is at least one substance which is selected from the group consisting of hydrofluoric acid, a salt of hydrofluoric acid, an acid that has an anion represented by general formula (a) as a conjugate base, and a salt of the acid that has an anion represented by general formula (a) as a conjugate base;

   [MFₙ]^{(n-k)-} (a)
a component (B) that is a compound represented by general formula (b);

   [MOₘ(OR)ₖ-₂ₘ]ₓ (b)

   wherein in general formulae (a) and (b), M is at least one element selected from the group consisting of boron, silicon, zirconium, antimony, niobium, aluminum, phosphorus and titanium, k is the oxidation number of M, m is an integer of 0 to k/2, x is a positive integer, R is one selected from the group consisting of a hydrogen atom, an alkali metal and an alkyl group, and n is the coordination number of fluoride ions with respect to M,
a component (C) that is an oxidant; a component (D) that is a tungsten corrosion inhibitor; a component (E) that is an organic solvent; and a component (F) that is water, wherein the component (E) contains at least one substance selected from the group consisting of tetrahydrofuran, acetone, and acetonitrile, and α represented by formula (I) is 0.2 to 1.1 inclusive. $α = \frac{\left[F\right]}{\sum \left(n\left(M\right)⋅\left[M\right]\right)}$ (I)

In formula (I), [F] is the molar concentration of the fluoride ions in the composition, [M] is the molar concentration of M in the composition, and n(M) is the coordination number of the fluoride ions with respect to M.

The cleaning method of the present invention is carried out in order to remove titanium nitride from a semiconductor substrate having titanium nitride, tungsten, and a low-dielectric-constant interlayer insulating film. By cleaning the semiconductor substrate using the cleaning method of the present invention, titanium nitride can be selectively removed from the semiconductor substrate having titanium nitride, tungsten, and the low-dielectric-constant interlayer insulating film.

That is, by cleaning the substrate using the cleaning method of the present invention, titanium nitride can be removed particularly while suppressing corrosion of tungsten.

Therefore, it becomes possible to clean and produce semiconductor substrates having fine metal wiring, and higher level of integration of semiconductor devices can be realized.

The temperature during cleaning in the cleaning method of the present invention is not particularly limited, but is preferably 20 to 80°C, and more preferably 25 to 70°C. Further, ultrasonic waves may be used during cleaning.

The cleaning time in the cleaning method of the present invention is not particularly limited, but is preferably 0.3 to 20 minutes, and more preferably 0.5 to 10 minutes.

In the cleaning method of the present invention, it is preferred to further perform rinsing with a rinse liquid containing water, alcohol or the like after cleaning.

In the cleaning method of the present invention, the method for bringing a substrate into contact with the composition for semiconductor substrate cleaning of the present invention is not particularly limited. For example, it is possible to employ a method for bringing a substrate into contact with the composition for semiconductor substrate cleaning of the present invention by means of dropping (single wafer spin process), spraying (spray treatment) or the like, a method for immersing a substrate in the composition for semiconductor substrate cleaning of the present invention, or the like. In the present invention, any of such methods can be used, and it is preferred to use a method for immersing a substrate in the composition for semiconductor substrate cleaning of the present invention.

### [Method for Producing Semiconductor Substrate]

The method for producing a semiconductor substrate of the present invention is a method for producing a semiconductor substrate, wherein the method includes a step of bringing a substrate having titanium nitride, tungsten and a low-dielectric-constant interlayer insulating film into contact with the aforementioned composition for semiconductor substrate cleaning.

That is, the method for producing a semiconductor substrate of the present invention is a method for producing a semiconductor substrate, wherein the method includes a step of bringing a substrate having titanium nitride, tungsten and a low-dielectric-constant interlayer insulating film into contact with a composition for semiconductor substrate cleaning, the composition containing:
a component (A) that is at least one substance which is selected from the group consisting of hydrofluoric acid, a salt of hydrofluoric acid, an acid that has an anion represented by general formula (a) as a conjugate base, and a salt of the acid that has an anion represented by general formula (a) as a conjugate base;

   [MFₙ]^{(n-k)-} (a)
a component (B) that is a compound represented by general formula (b);

   [MOₘ(OR)ₖ₋₂ₘ]ₓ (b)

   wherein in general formulae (a) and (b), M is at least one element selected from the group consisting of boron, silicon, zirconium, antimony, niobium, aluminum, phosphorus and titanium, k is the oxidation number of M, m is an integer of 0 to k/2, x is a positive integer, R is one selected from the group consisting of a hydrogen atom, an alkali metal and an alkyl group, and n is the coordination number of fluoride ions with respect to M,
a component (C) that is an oxidant; a component (D) that is a tungsten corrosion inhibitor; a component (E) that is an organic solvent; and a component (F) that is water, wherein the component (E) contains at least one substance selected from the group consisting of tetrahydrofuran, acetone, and acetonitrile, and α represented by formula (I) is 0.2 to 1.1 inclusive. $α = \frac{\left[F\right]}{\sum \left(n\left(M\right)⋅\left[M\right]\right)}$ (I)

In formula (I), [F] is the molar concentration of the fluoride ions in the composition, [M] is the molar concentration of M in the composition, and n(M) is the coordination number of the fluoride ions with respect to M.

The method for producing a semiconductor substrate will be specifically described below.

Firstly, a barrier insulating film, a low-dielectric-constant interlayer insulating film, a hard mask, and a photoresist are laminated on a substrate made of silicon or the like having a barrier metal, a metal wiring, a low-dielectric-constant interlayer insulating film, and if necessary, a cap metal, and then the photoresist is subjected to selective exposure and development treatment to form a photoresist pattern. Next, the photoresist pattern is transferred onto the hard mask by dry etching. After that, the photoresist pattern is removed, and the low-dielectric-constant interlayer insulating film and the barrier insulating film are subjected to dry etching treatment using the hard mask as an etching mask. Then, the step of bringing the substrate into contact with the composition for semiconductor substrate cleaning, which is the step described above, is carried out, thereby obtaining a semiconductor substrate having a desired metal wiring pattern.

In this regard, as a substrate material, silicon, amorphous silicon, polysilicon, glass, etc. are used. As the barrier metal, tantalum, tantalum nitride, ruthenium, manganese, magnesium, cobalt, oxides thereof, etc. are used.

As described above, the low-dielectric-constant interlayer insulating film is preferably a film made of a silicon compound, more preferably a TEOS film, a silicon dioxide film, or a silicon-containing organic polymer film, even more preferably a TEOS film or a silicon dioxide film, and still more preferably a TEOS film.

The silicon dioxide film is preferably a carbon-doped silicon dioxide film.

Among TEOS films, a PE-TEOS film (plasma TEOS film) is preferred.

As the barrier insulating film, silicon nitride, silicon carbide, silicon carbonitride, etc. are used. As the hard mask, titanium, titanium nitride, etc. are used. In the present invention, titanium nitride is contained in the hard mask.

The metal wiring contains tungsten. The metal wiring may be made of tungsten alone or a tungsten alloy, but is preferably made of tungsten alone.

The step of bringing a substrate having titanium nitride, tungsten and the low-dielectric-constant interlayer insulating film into contact with the composition for semiconductor substrate cleaning, which is the step included in the production method of the present invention, is preferably carried out under the same conditions as those for the cleaning method described in [Method for Cleaning Semiconductor Substrate] above.

According to the method for producing a semiconductor substrate of the present invention, since the method has a step in which unnecessary components can be removed while leaving necessary components by using the composition for semiconductor substrate cleaning, it becomes possible to produce semiconductor substrates having fine metal wiring, and higher level of integration of semiconductor devices can be realized.

### EXAMPLES

Hereinafter, the present invention will be more specifically described by way of examples, but the present invention is not limited thereto.

### <Analysis Methods/Evaluation Methods>

### (1) Etching Rate (ER)

### (1-1) Etching Rates (ER) of Titanium Nitride and Low-Dielectric-Constant Interlayer Insulating Film

A "wafer with titanium nitride film" having a titanium nitride layer on a silicon wafer, and a "wafer with TEOS film" having a plasma TEOS (PE-TEOS) layer, which is a type of low-dielectric-constant interlayer insulating film, on a silicon wafer were prepared.

Next, the film thicknesses were measured. The film thickness of the titanium nitride layer of the "wafer with titanium nitride film" was measured using X-Ray Fluorescent Analyzer SEA1200VX (manufactured by SII Nano Technology Inc.). The film thickness of the PE-TEOS layer of the "wafer with TEOS film" was measured using an optical film thickness gauge n&k 1280 (manufactured by n&k Technology Inc.).

Next, the temperature of each of the compositions for semiconductor substrate cleaning of Examples and Comparative Examples was adjusted to 60°C, and each wafer with film was immersed therein for 1 to 5 minutes and subsequently rinsed with ultrapure water at 25°C, and the film thickness of each wafer was measured again according to the above-described measurement method.

The etching rate (ER) (Å/min) of each material was calculated by dividing the difference between the film thicknesses before and after immersion in the composition for semiconductor substrate cleaning by the treatment time.

### Judgment of Titanium Nitride Etching Rate

AA: 160 Å/min or more
A: 120 Å/min or more but less than 160 Å/min
B: 80 Å/min or more but less than 120 Å/min
C: less than 80 Å/min

### Judgment of TEOS Etching Rate

AA: less than 1 Å/min
A: 1 Å/min or more but less than 2 Å/min
B: 2 Å/min or more but less than 3 Å/min
C: 3 Å/min or more

### (1-2) Etching Rate (ER) of Tungsten

A "wafer with tungsten film" having a PVD-deposited tungsten layer on a silicon wafer was prepared.

Next, the temperature of each of the compositions for semiconductor substrate cleaning of Examples and Comparative Examples was adjusted to 60°C, and the wafer with tungsten film was immersed therein for 1 to 5 minutes. The cleaning solution after immersion ("composition used" in the formula below) was diluted 10 to 30-fold with 1% by mass solution of ammonia, and the tungsten concentration was measured using an inductively coupled plasma optical emission spectrometer iCAP DUO-6300 (manufactured by Thermo Fisher). The tungsten concentration (W concentration) before dilution was calculated and substituted into the formula below to calculate the etching rate (ER) of tungsten (ER of W) (Å/min). In the formula below, "19.30 g/cm³" is the density of tungsten, and "wafer area" is the area of the tungsten film on the wafer.

### Judgment of Tungsten Etching Rate

AA: less than 1 Å/min
A: 1 Å/min or more but less than 2 Å/min
B: 2 Å/min or more but less than 3 Å/min
C: 3 Å/min or more $\begin{matrix}ER of W \left(Å/min\right) = \frac{W concentration before dilution \left(μg/kg\right) \times Amount of composition used \left(g\right)}{19.30 \left({g / cm}^{3}\right) \times Wafer area \left({cm}^{2}\right)} \times \frac{1}{10} \\ \times \frac{1}{Immersion time \left(min\right)}\end{matrix}$

### (2) Evaluation of Precipitation

### Judgment of Presence or Absence of Precipitation

A: No precipitation was seen by visual observation
C: Precipitation was seen by visual observation

### <Composition for Semiconductor Substrate Cleaning>

### (Example 1)

Hexafluorosilicic acid (component (A)), potassium silicate (component (B)), periodic acid (component (C)), benzalkonium chloride (component (D)), tetrahydrofuran (component (E)), and water (ultrapure water) were mixed in a manner such that the concentrations thereof became those shown in Table 1 to obtain a composition for semiconductor substrate cleaning.

### (Examples 2 to 10 and Comparative Examples 1 to 6)

A composition for semiconductor substrate cleaning was obtained in a manner similar to that in Example 1, except that the components and concentrations in Example 1 were changed to those shown in Table 1. Note that in Comparative Examples 2 to 6, the component (E) was not mixed.

Each composition for semiconductor substrate cleaning was analyzed and evaluated using the aforementioned analysis methods/evaluation methods. The results of analysis and evaluation of the compositions for semiconductor substrate cleaning obtained in Examples and Comparative Examples are shown in Table 1.

**Table 1**

| | Component (A) | Concentration [wt%] | Component (B) | Concentration [wt%] | Component (C) | Concentration [wt%] | Component (D) | Concentraation [wt%] | Component (E) | Concentration [wt%] | α | ER of TiN | ER of W | ER of TEOS | Precipitation |
|---|---|---|---|---|---|---|---|---|---|---|---|---|---|---|---|
| Example 1 | Hexafluorosilicic acid | 3 | Potassium silicate | 0.2 | Periodic acid | 0.01 | Benzalkonium chloride | 0.05 | Tetrahydrofuran | 5 | 0.94 | A | AA | A | A |
| Example 2 | Hexafluorosilicic acid | 3 | Potassium silicate | 0.2 | Periodic acid | 0.01 | Benzalkonium chloride | 0.05 | Acetone | 8 | 0.94 | AA | A | A | A |
| Example 3 | Hexafluorosilicic acid | 3 | Potassium silicate | 0.2 | Periodic acid | 0.01 | Benzalkonium chloride | 0.05 | Acetonitrile | 5 | 0.94 | A | A | A | A |
| Example 4 | Hexafluorosilicic acid | 3 | Potassium silicate | 0.2 | Iodic acid | 0.01 | Benzalkonium chloride | 0.05 | Tetrahydrofuran | 5 | 0.94 | A | AA | A | A |
| Example 5 | Hexafluorosilicic acid | 3 | Potassium silicate | 0.2 | Vanadium oxide | 0.005 | Benzalkonium chloride | 0.05 | Tetrahydrofuran | 5 | 0.94 | B | AA | A | A |
| Example 6 | Hexafluorosilicic acid | 2 | Potassium silicate | 0.1 | Periodic acid | 0.01 | Dodecylpyridinium chloride | 0.12 | Tetrahydrofuran | 5 | 0.96 | AA | A | AA | A |
| Example 7 | Hexafluorosilicic acid | 2 | Potassium silicate | 0.1 | Periodic acid | 0.01 | Dodecyldimethylbenzylammonium chloride | 0.06 | Tetrahydrofuran | 5 | 0.96 | A | A | A | A |
| Example 8 | Hexafluorosilicic acid | 2 | Potassium silicate | 0.1 | Periodic acid | 0.01 | Benzethonium chloride | 0.01 | Tetrahydrofuran | 5 | 0.96 | AA | A | A | A |
| Example 9 | Hexafluorosilicic acid | 2 | Sodium metasilicate | 0.05 | Periodic acid | 0.01 | Benzalkonium chloride | 0.05 | Tetrahydrofuran | 5 | 0.97 | B | A | B | A |
| Example 10 | Tetrafluoroboric acid | 2 | Boric acid | 0.5 | Vanadium oxide | 0.005 | Benzalkonium chloride | 0.005 | Tetrahydrofuran | 5 | 0.74 | B | B | AA | A |
| Comparative Example 1 | Hexafluorosilicic acid | 3 | Potassium silicate | 0.2 | Periodic acid | 0.01 | Benzalkonium chloride | 0.05 | Ethylene glycol | 5 | 0.94 | - | - | - | C |
| Comparative Example 2 | Hexafluorosilicic acid | 3 | Potassium silicate | 0.2 | Periodic acid | 0.01 | Benzalkonium chloride | 0.05 | - | - | 0.94 | - | - | - | C |
| Comparative Example 3 | Hexafluorosilicic acid | 3 | Potassium silicate | 0.2 | Periodic acid | 0.01 | Benzalkonium chloride | 0.005 | - | - | 0.94 | A | C | AA | A |
| Comparative Example 4 | Hexafluorosilicic acid | 3 | Potassium silicate | 0.05 | Periodic acid | 0.01 | Benzalkonium chloride | 0.05 | - | - | 0.98 | A | C | C | A |
| Comparative Example 5 | Hydrofluoric acid | 1 | Potassium silicate | 0.2 | Iodic acid | 0.01 | Benzalkonium chloride | 0.05 | - | - | 0.84 | AA | C | C | A |
| Comparative Example 6 | Hexafluorosilicic acid | 1.2 | Tetramethyl orthosilicate | 0.3 | Periodic acid | 0.003 | Benzalkonium chloride | 0.004 | - | - | 0.81 | C | AA | AA | A |

## Claims

1. A composition for semiconductor substrate cleaning, the composition comprising:
a component (A) that is at least one substance selected from the group consisting of hydrofluoric acid, a salt of hydrofluoric acid, an acid that has an anion represented by general formula (a) as a conjugate base, and a salt of the acid that has an anion represented by general formula (a) as a conjugate base;
[MFₙ]^{(n-k)-} (a)
a component (B) that is a compound represented by general formula (b);
[MOₘ(OR)ₖ₋₂ₘ]ₖ (b)
wherein in general formulae (a) and (b), M is at least one element selected from the group consisting of boron, silicon, zirconium, antimony, niobium, aluminum, phosphorus and titanium, k is an oxidation number of M, m is an integer of 0 to k/2, x is a positive integer, R is one selected from the group consisting of a hydrogen atom, an alkali metal and an alkyl group, and n is a coordination number of fluoride ions with respect to M,
a component (C) that is an oxidant;
a component (D) that is a tungsten corrosion inhibitor;
a component (E) that is an organic solvent; and
a component (F) that is water, wherein
the component (E) comprises at least one substance selected from the group consisting of tetrahydrofuran, acetone, and acetonitrile, and
α represented by formula (I) is 0.2 to 1.1 inclusive: $α = \frac{\left[F\right]}{\sum \left(n\left(M\right)⋅\left[M\right]\right)}$ (I)
wherein in formula (I), [F] is a molar concentration of the fluoride ions in the composition, [M] is a molar concentration of M in the composition, and n(M) is a coordination number of the fluoride ions with respect to M.

2. The composition for semiconductor substrate cleaning according to claim 1, wherein the component (A) comprises at least one substance selected from the group consisting of hydrofluoric acid, hexafluorosilicic acid, tetrafluoroboric acid, a salt of hexafluorosilicic acid, and a salt of tetrafluoroboric acid.

3. The composition for semiconductor substrate cleaning according to claim 1 or 2, wherein the component (B) comprises at least one substance selected from the group consisting of boric acid, a salt of boric acid, silicic acid, a salt of silicic acid, orthosilicic acid, and a salt of orthosilicic acid.

4. The composition for semiconductor substrate cleaning according to any one of claims 1 to 3, wherein the component (C) comprises at least one substance selected from the group consisting of vanadium(V) oxide, vanadic acid (V), a salt of vanadic acid (V), iodic acid, a salt of iodic acid, orthoperiodic acid, and a salt of orthoperiodic acid.

5. The composition for semiconductor substrate cleaning according to any one of claims 1 to 4, wherein the component (D) comprises at least one substance selected from the group consisting of benzethonium chloride, benzalkonium chloride, alkylpyridinium chloride, and quaternary ammonium salt.

6. The composition for semiconductor substrate cleaning according to any one of claims 1 to 5, which is used for removing titanium nitride from a semiconductor substrate having titanium nitride, tungsten and a low-dielectric-constant interlayer insulating film.

7. The composition for semiconductor substrate cleaning according to any one of claims 1 to 6, wherein a content of the component (A) is 0.1 to 10% by mass relative to a total amount of the composition for semiconductor substrate cleaning.

8. The composition for semiconductor substrate cleaning according to any one of claims 1 to 7, wherein a content of the component (B) is 0.005 to 5% by mass relative to a total amount of the composition for semiconductor substrate cleaning.

9. The composition for semiconductor substrate cleaning according to any one of claims 1 to 8, wherein a content of the component (C) is 0.0005 to 1% by mass relative to a total amount of the composition for semiconductor substrate cleaning.

10. The composition for semiconductor substrate cleaning according to any one of claims 1 to 9, wherein a content of the component (D) is 0.0005 to 1% by mass relative to a total amount of the composition for semiconductor substrate cleaning.

11. The composition for semiconductor substrate cleaning according to any one of claims 1 to 10, wherein a content of the component (E) is 0.1 to 50% by mass relative to a total amount of the composition for semiconductor substrate cleaning.

12. The composition for semiconductor substrate cleaning according to any one of claims 1 to 11, wherein the component (A) is at least one substance selected from the group consisting of an acid that has an anion represented by general formula (a) as a conjugate base and a salt of the acid that has an anion represented by general formula (a) as a conjugate base, and wherein a ratio between a content (mol) of the component (A) and a content (mol) of the component (B) [(A)/(B)] is 1 to 100.

13. The composition for semiconductor substrate cleaning according to any one of claims 1 to 12, wherein when a substrate having tungsten and titanium nitride is immersed in the composition for semiconductor substrate cleaning and kept at 60°C, titanium nitride is removed at a removal rate of 80 Å/min or more and tungsten is removed at a removal rate of 3 Å/min or less.

14. The composition for semiconductor substrate cleaning according to any one of claims 1 to 12, wherein when a substrate having a low-dielectric-constant interlayer insulating film and titanium nitride is immersed in the composition for semiconductor substrate cleaning and kept at 60°C, titanium nitride is removed at a removal rate of 80 Å/min or more and the low-dielectric-constant interlayer insulating film is removed at a removal rate of 3 Å/min or less.

15. A method for cleaning a semiconductor substrate, the method comprising bringing a substrate having titanium nitride, tungsten and a low-dielectric-constant interlayer insulating film into contact with the composition for semiconductor substrate cleaning according to any one of claims 1 to 14.

16. A method for producing a semiconductor substrate, the method comprising a step of bringing a substrate having titanium nitride, tungsten and a low-dielectric-constant interlayer insulating film into contact with the composition for semiconductor substrate cleaning according to any one of claims 1 to 14.
